(19)

Europäisches Patentamt

European Patent Office

Office européen des brevets

(11) **EP 4 664 120 A1**

(12) **EUROPEAN PATENT APPLICATION**

(43) Date of publication:
**17.12.2025  Bulletin 2025/51**

(21) Application number: **25182374.6**

(22) Date of filing: **12.06.2025**

(51) International Patent Classification (IPC):
**G01R 27/02** (2006.01)    **G01R 27/18** (2006.01)
**G01R 31/40** (2020.01)    **G01R 31/52** (2020.01)

(52) Cooperative Patent Classification (CPC):
**G01R 27/18; G01R 27/025; G01R 31/40;
G01R 31/52**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  **13.06.2024   US 202463659578 P**

(71) Applicant: **Delta Electronics, Inc.
Neihu, Taipei 11491 (TW)**

(72) Inventors:
 • **Hu, Boxue**
   **Morrisville, NC, 27560 (US)**
 • **Wang, Ruxi**
   **Morrisville, NC, 27560 (US)**
 • **Zhang, Chi**
   **Morrisville, NC, 27560 (US)**
 • **Anurag, Anup**
   **Morrisville, NC, 27560 (US)**
 • **Liu, Jian**
   **Morrisville, NC, 27560 (US)**
 • **Barbosa, Peter Mantovanelli**
   **Morrisville, NC, 27560 (US)**

(74) Representative: **Uexküll & Stolberg
Partnerschaft von
Patent- und Rechtsanwälten mbB
Beselerstraße 4
22607 Hamburg (DE)**

(54) **DC POWER SYSTEM AND INSULATION RESISTANCE MONITOR DEVICE THEREOF**

(57)    A DC power system (1a, 1b, 1c, 1d, 1e, 1f) and an insulation resistance monitor device (14) thereof are provided. The DC power system (1a, 1b, 1c, 1d, 1e, 1f) includes positive, neutral and negative lines (11, 12, 13), a protective earthing terminal (PE) and a grounding resistor (Rgnd). The grounding resistor (Rgnd) is electrically connected between the neutral line (12) and the protective earthing terminal (PE). The insulation resistance monitor device (14) includes a first resistor (R1), a first sensing resistor (Rs) and a first detection circuit (141). The first resistor (R1) is coupled to the positive or negative line (11, 13). The first sensing resistor (R1) is coupled between a second terminal of the first resistor (R1) and the protective earthing terminal (PE). The first detection circuit (141) is electrically connected to the first sensing resistor (Rs), and is configured to measure a sensing voltage across the first sensing resistor (Rs) and detect whether an insulation resistance between the protective earthing terminal (PE) and any of the positive, neutral and negative lines (11, 12, 13) is abnormal according to the sensing voltage.

1a

FIG. 3A

EP 4 664 120 A1

**Description**

FIELD OF THE APPLICATION

The present disclosure relates to a DC power system and an insulation resistance monitor device thereof, and more particularly to a bipolar DC power system and an insulation resistance monitor device thereof.

BACKGROUND OF THE APPLICATION

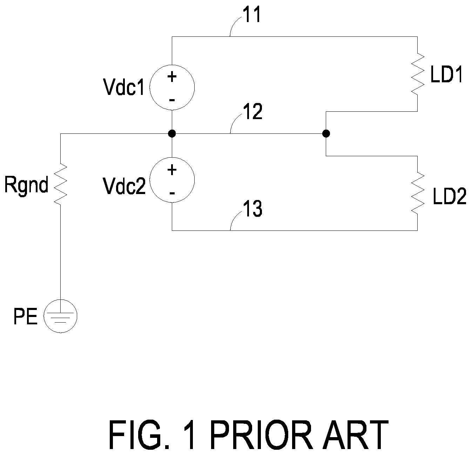

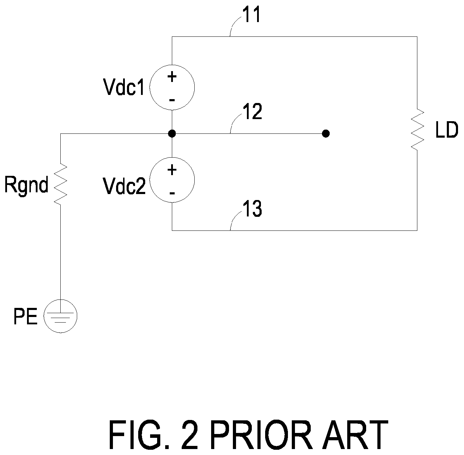

Bipolar DC power systems, such as +/-400 Vdc distribution, become popular in application areas like data centers, solar farms, and electric vehicle charging stations. FIG. 1 is a schematic circuit diagram illustrating a conventional bipolar DC power system with DC-IT earthing configuration. DC sources Vdc1 and Vdc2 are outputs of power electronics converters, such as solid-state transformers, power conditioning systems, maximum power point tracking (MPPT) circuits of solar panels etc. Magnitudes of the DC sources Vdc1 and Vdc2 are regulated to be equal. Electric power is transferred to DC loads LD1 and LD2 through three power lines, which are a positive line 11, a neutral line 12, and a negative line 13. A high impedance provided by a grounding resistor Rgnd exists between the neutral line 12 and a protective earthing terminal PE. The DC load LD1 represents DC power loads installed on the positive and neutral lines 11 and 12, and the DC load LD2 represents DC power loads installed on the negative and neutral lines 13 and 12. FIG. 2 is a schematic circuit diagram illustrating another conventional bipolar DC power system with DC-IT earthing configuration. Different from the system shown in FIG. 1, this bipolar DC power system does not provide the neutral line 12 to the DC power load. The DC power load, i.e., the DC load LD, receives electric power through the positive and negative lines 11 and 13. It is important to monitor the insulation resistances between lines and protective earth for safety purpose.

In conventional insulation resistance monitor devices for DC power systems, insulation resistances between a positive line to a protective earth and between a negative line to the protective earth, respectively, are measured by using multiple resistors and switches. Further, the insulation resistances are measured separately in different steps of a certain measurement procedure. Therefore, the conventional solutions are complex and of high cost. In addition, the conventional insulation resistance monitor devices are developed for the DC power system with only one DC source, namely there is no neutral line in such a DC power system. Thus, the conventional solutions do not measure the insulation resistance between the neutral line and the protective earth.

Therefore, there is a need of providing a DC power system and an insulation resistance monitor device thereof in order to overcome the drawbacks of the conventional technologies.

SUMMARY OF THE APPLICATION

The present disclosure provides a DC power system and an insulation resistance monitor device thereof. The insulation resistance monitor device is able to detect and distinguish the insulation degradation or failure between protective earth and any of positive line, neutral line, and negative line.

In accordance with an aspect of the present disclosure, an insulation resistance monitor device adapted to a DC power system is provided. The DC power system includes a positive line, a neutral line, a negative line, a protective earthing terminal, and a grounding resistor. The grounding resistor is electrically connected between the neutral line and the protective earthing terminal. The insulation resistance monitor device includes a first resistor, a first sensing resistor, and a first detection circuit. The first resistor has a first terminal coupled to the positive line or the negative line of the DC power system. The first sensing resistor has a first terminal coupled to a second terminal of the first resistor and a second terminal coupled to the protective earthing terminal. The first detection circuit is electrically connected to the first and second terminals of the first sensing resistor, and is configured to measure a sensing voltage across the first sensing resistor and detect whether an insulation resistance between the protective earthing terminal and any of the positive line, the neutral line and the negative line is abnormal according to the sensing voltage.

In accordance with an aspect of the present disclosure, a DC power system is provided. The DC power system includes a positive line, a neutral line, a negative line, a protective earthing terminal, a first DC source, a second DC source, a grounding resistor, and an insulation resistance monitor device. The first DC source has a positive terminal electrically connected to the positive line and a negative terminal electrically connected to the neutral line. The second DC source has a positive terminal electrically connected to the neutral line and a negative terminal electrically connected to the negative line. The grounding resistor is electrically connected between the neutral line and the protective earthing terminal. The insulation resistance monitor device includes a first resistor, a first sensing resistor and a first detection circuit. The first resistor has a first terminal coupled to the positive line or the negative line of the DC power system. The first sensing resistor has a first terminal coupled to a second terminal of the first resistor and a second terminal coupled to the protective earthing terminal. The first detection circuit is electrically connected to the first and second terminals of the first sensing resistor, and is configured to measure a sensing voltage across the first sensing resistor and detect whether an insulation resistance between the protective earthing terminal and any of the positive line, the neutral line and the negative line is abnormal according to the sensing voltage.

The above contents of the present disclosure will become more readily apparent to those ordinarily skilled in the art after reviewing the following detailed description and accompanying drawings, in which:

BRIEF DESCRIPTION OF THE DRAWINGS

FIG. 1 is a schematic circuit diagram illustrating a conventional bipolar DC power system with DC-IT earthing configuration;

FIG. 2 is a schematic circuit diagram illustrating another conventional bipolar DC power system with DC-IT earthing configuration;

FIG. 3A is a schematic circuit diagram illustrating a DC power system according to a first embodiment of the present disclosure;

FIG. 3B schematically shows a variant of the DC power system of FIG. 3A;

FIG. 4 schematically shows relations between the sensing voltage and the status of insulation resistances in the DC power system of FIG. 3A;

FIG. 5 schematically shows the DC power system of FIG. 3A with an insulation resistance between the protective earthing terminal and the positive line;

FIG. 6 schematically shows a simplified equivalent circuit of FIG. 5;

FIG. 7 schematically shows the DC power system of FIG. 3A with an insulation resistance between the protective earthing terminal and the negative line;

FIG. 8 schematically shows a simplified equivalent circuit of FIG. 7;

FIG. 9 is a schematic circuit diagram illustrating a DC power system according to a second embodiment of the present disclosure;

FIG. 10 is a schematic circuit diagram illustrating a DC power system according to a third embodiment of the present disclosure;

FIG. 11 is a schematic circuit diagram illustrating a DC power system according to a fourth embodiment of the present disclosure;

FIG. 12 is a schematic circuit diagram illustrating a DC power system according to a fifth embodiment of the present disclosure;

FIG. 13 schematically shows relations between the sensing voltage and the status of insulation resistances in the DC power system of FIG. 12; and

FIG. 14 is a schematic circuit diagram illustrating a DC power system according to a sixth embodiment of the present disclosure.

DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

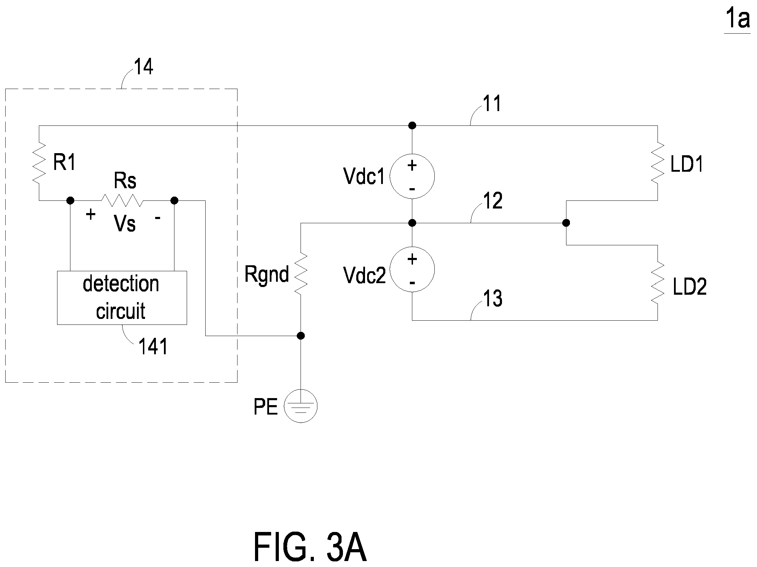

Please refer to FIG. 3A. FIG. 3A is a schematic circuit diagram illustrating a DC power system according to a first embodiment of the present disclosure. As shown in FIG. 3A, the DC power system 1a includes a positive line 11, a neutral line 12, a negative line 13, DC sources Vdc1 and Vdc2, DC loads LD1 and LD2, a grounding resistor Rgnd, a protective earthing terminal PE, and an insulation resistance monitor device 14. The positive and negative terminals of the DC source Vdc1 are electrically connected to the positive line 11 and the neutral line 12 respectively, and the positive and negative terminals of the DC source Vdc2 are electrically connected to the neutral line 12 and the negative line 13 respectively. The DC load LD1 is electrically connected to the DC source Vdc1 through the positive line 11 and the neutral line 12, and the DC load LD2 is electrically connected to the DC source Vdc2 through the neutral line 12 and the negative line 13. The voltage magnitudes of the DC sources Vdc1 and Vdc2 are equal. It should be noted that each of the DC sources Vdc1 and Vdc2 may be formed by a single power source or multiple power sources electrically connected in parallel, and the number of the power sources forming the DC sources Vdc1 and Vdc2 may be equal or unequal. In addition, the DC load LD1 represents one or more power loads which receive power from the DC source Vdc1 through the positive line 11 and the neutral line 12, and the DC load LD2 represents one or more power loads which receive power from the DC source Vdc2 through the neutral line 12 and the negative line 13. Alternatively, the DC loads LD1 and LD2 may form a single load and represent two load parts receiving power from the DC sources Vdc1 and Vdc2 respectively. Moreover, the actual implementation of the DC loads LD1 and LD2 are not limited. For example, the DC loads LD1 and LD2 may be power supply units for XPUs in data centers, chargers of EV batteries, grid inverters of solar farms, etc.

The grounding resistor Rgnd is electrically connected between the neutral line 12 and the protective earthing terminal PE, and is configured to guarantee personnel safety in case of touching any power line. In specific, when a person touches the positive line 11 or the negative line 13, the grounding resistor Rgnd can limit the current flowing through the person. Therefore, it is important to monitor the resistance of grounding resistor Rgnd for safety purpose.

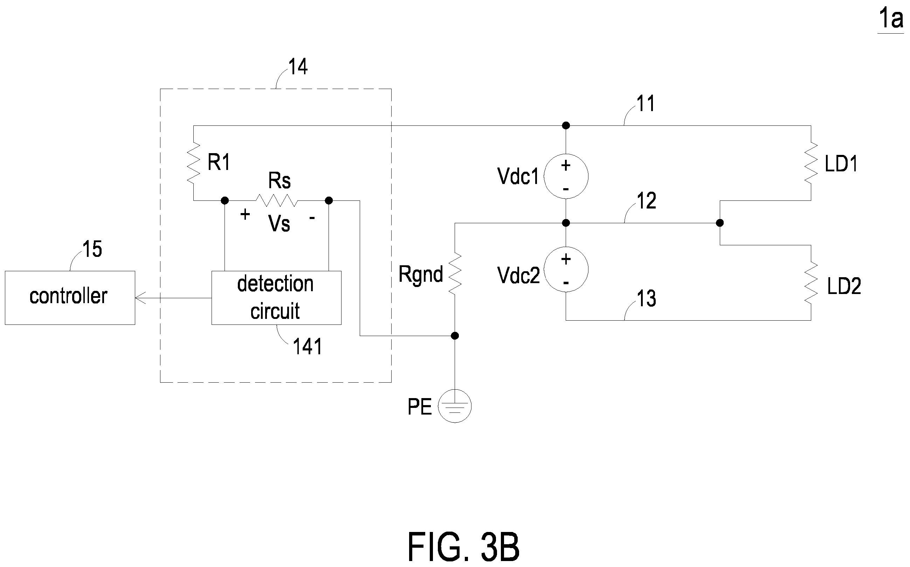

The insulation resistance monitor device 14 includes a first resistor R1, a sensing resistor Rs (also referred to as a first sensing resistor) and a detection circuit 141 (also referred to as a first detection circuit). In this embodiment, first and second terminals of the first resistor R1 are respectively coupled to the positive line 11 and a first terminal of the sensing resistor Rs, and a second terminal of the sensing resistor Rs is coupled to the protective earthing terminal PE. The detection circuit 141 is electrically connected to the first and second terminals of the sensing resistor Rs, and is configured to measure a sensing voltage Vs across the sensing resistor Rs, where the sensing voltage Vs reflects whether an insulation resistance between the protective earthing terminal PE and any of the positive line 11, the neutral line 12 and the negative line 13 is abnormal. In an embodiment, the detection circuit 141 detects whether the insulation resistance between the protective earthing terminal PE and any of the positive line 11, the neutral line 12 and the negative line 13 is abnormal according to the sensing voltage Vs (e.g., through comparing the sensing voltage Vs with predetermined threshold voltages). The insulation resistance between the protective earthing terminal PE and the neutral line 12 is abnormal when it is too high or too low (e.g., due to degradation or failure). The insulation resistance between the protective earthing terminal PE and the positive line 11 is abnormal when it is too low (e.g., due to degradation or failure). The insulation resistance between the protective earthing terminal PE and the negative line 13 is abnormal when it is too low (e.g., due to degradation or failure). In addition, the step of determining whether the insulation resistance is abnormal is not limited to be performed by the detection circuit 141. For example, in another embodiment, the detection circuit 141 may transit a sensing signal reflecting the sensing voltage Vs to a controller 15 of the DC power system 1a, as shown in FIG. 3B, and the controller 15 determines whether the insulation resistance is abnormal according to the sensing voltage Vs reflected by the sensing signal.

The sensing voltage Vs of the sensing resistor Rs can be written as:

$$Vs = \frac{Rs}{R1+Rs+Rgnd} \cdot Vdc1 \qquad (1)$$

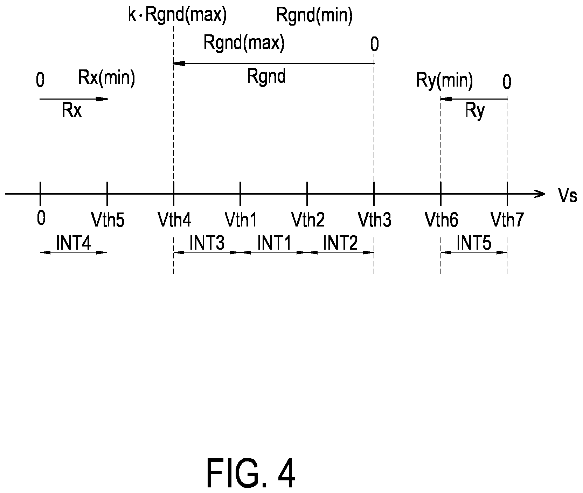

Please refer to FIG. 3A in conjunction with FIG. 4. FIG. 4 schematically shows relations between the sensing voltage Vs and the status of insulation resistances in the DC power system 1a of FIG. 3A. Under normal condition (i.e., the insulation resistance between the protective earthing terminal PE and any of the positive line 11, the neutral line 12 and the negative line 13 is normal), the resistance of the grounding resistor Rgnd is within an acceptable tolerance range. Assuming that the acceptable tolerance range is from a lower bound of grounding resistance Rgnd(min) to an upper bound of grounding resistance Rgnd(max), the sensing voltage Vs under the normal condition ranges from a first threshold voltage Vth1 to a second threshold voltage Vth2, as represented by interval INT1 in FIG. 4.

$$Vth1 = \frac{Rs}{R1+Rs+Rgnd(max)} \cdot Vdc1 \qquad (2)$$

$$Vth2 = \frac{Rs}{R1+Rs+Rgnd(min)} \cdot Vdc1 \qquad (3)$$

Consequently, if the insulation resistance between the protective earthing terminal PE and any of the positive line 11, the neutral line 12 and the negative line 13 is normal (i.e., the DC power system 1a is under normal state), the sensing voltage Vs measured by the detection circuit 141 would be within the interval INT1.

If the sensing voltage Vs is outside of the range from the first threshold voltage Vth1 to the second threshold voltage Vth2, it indicates that an insulation degradation or failure exists. The specific type of insulation degradation or failure can be further decided according to the sensing voltage Vs, which would be described in detail as follows.

Degradation or failure of the insulation resistance between the neutral line 12 and the protective earthing terminal PE may occur due to a few reasons, such as degradation of the insulation layer of neutral line wire, the grounding resistor Rgnd aging, foreign objects bridging the neutral line 12 and the protective earthing terminal PE. If the insulation resistance between the neutral line 12 and the protective earthing terminal PE (i.e., the resistance of grounding resistor Rgnd) decreases from the lower bound of grounding resistance Rgnd(min) to a value close to or equal to zero, the sensing voltage Vs increases from the second threshold voltage Vth2 to a third threshold voltage Vth3 correspondingly, as represented by interval INT2 in FIG. 4. The sensing voltage Vs within the interval INT2 reflects that the insulation resistance between the neutral line 12 and the protective earthing terminal PE is too low.

$$Vth3 = \frac{Rs}{R1+Rs} \cdot Vdc1 \qquad (4)$$

If the resistance of grounding resistor Rgnd increases from the upper bound of grounding resistance Rgnd(max) to k times of the upper bound of grounding resistance Rgnd(max), the sensing voltage Vs decreases from the first threshold voltage Vth1 to a fourth threshold voltage Vth4 correspondingly, represented by interval INT3 in FIG. 4. The coefficient k is an integer greater than 1 and may be set according to actual requirements. The sensing voltage Vs within the interval INT3 reflects that the insulation resistance between the neutral line 12 and the protective earthing terminal PE is too high.

$$Vth4 = \frac{Rs}{R1+Rs+k \cdot Rgnd(max)} \cdot Vdc1 \qquad (5)$$

Consequently, if the insulation resistance between the neutral line 12 and the protective earthing terminal PE is too low or too high, the sensing voltage Vs measured by detection circuit 14 would be within the interval INT2 or INT3. In other words, the sensing voltage Vs within the interval INT2 or INT3 reflects that the insulation resistance between the neutral line 12 and the protective earthing terminal PE is abnormal.

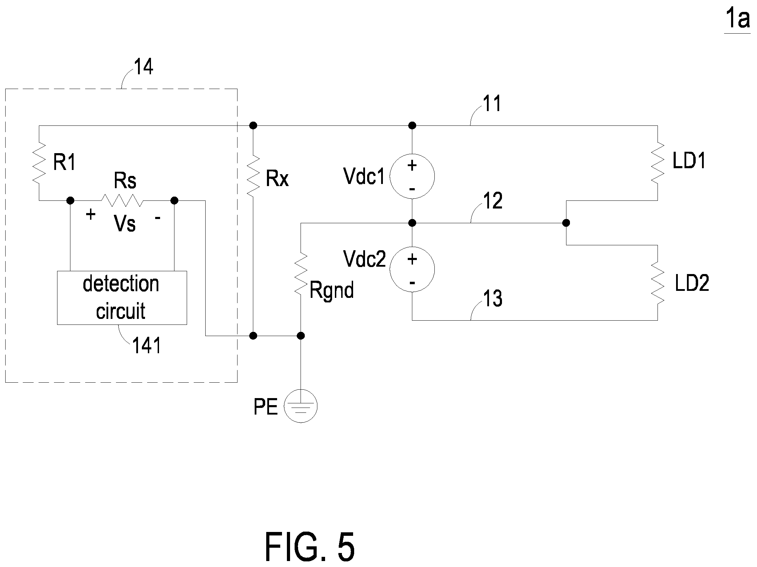

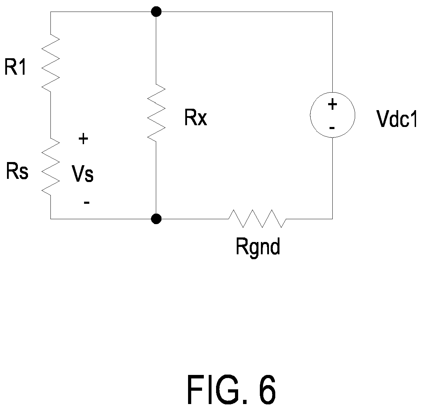

An insulation resistance between the positive line 11 and the protective earthing terminal PE may be represented by a resistor Rx across the positive line 11 and the protective earthing terminal PE, as shown in FIG. 5. FIG. 6 schematically shows a simplified equivalent circuit of FIG. 5. Please refer to FIG. 5 and FIG. 6 in conjunction with FIG. 4. The insulation resistance between the positive line 11 and the protective earthing terminal PE is determined to be abnormal if the resistance of resistor Rx is less than a preset minimum value Rx(min). When the resistance of resistor Rx is equal to a value close to or equal to zero, the sensing voltage Vs is closing or equal to zero; and when the resistance of resistor Rx is equal to the preset minimum value Rx(min), the sensing voltage Vs is equal to a fifth threshold voltage Vth5. In other words, if the resistance of resistor Rx decreases from the preset minimum value Rx(min) to a value, for example, approaching zero or a value that the detection device indicates as substantially zero, the sensing voltage Vs decreases from the fifth threshold voltage Vth5 to about or equal to zero correspondingly, represented by interval INT4 in FIG. 4.

$$Vth5 = \frac{Rx(min) \cdot Rs}{(R1+Rs)(Rgnd+Rx(min))+Rgnd \cdot Rx(min)} \cdot Vdc1 \qquad (6)$$

Consequently, if the insulation resistance between the positive line 11 and the protective earthing terminal PE is abnormal, the sensing voltage Vs measured by detection circuit 14 would be within the interval INT4.

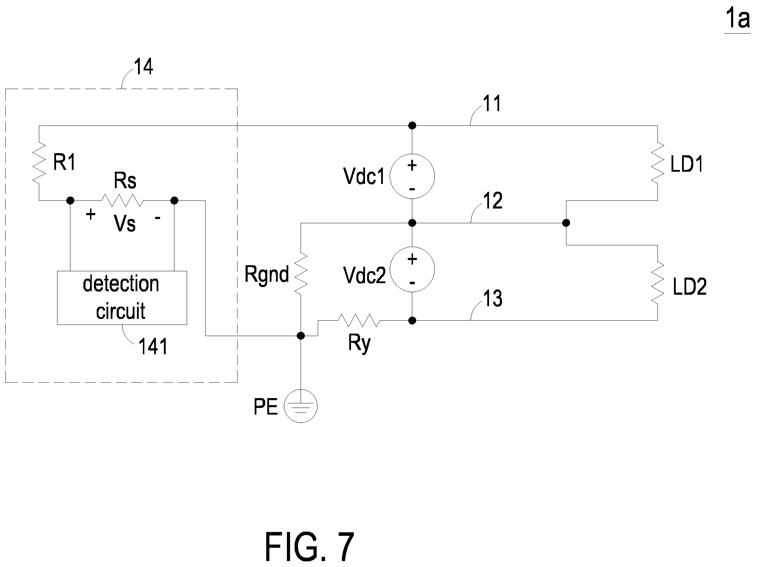

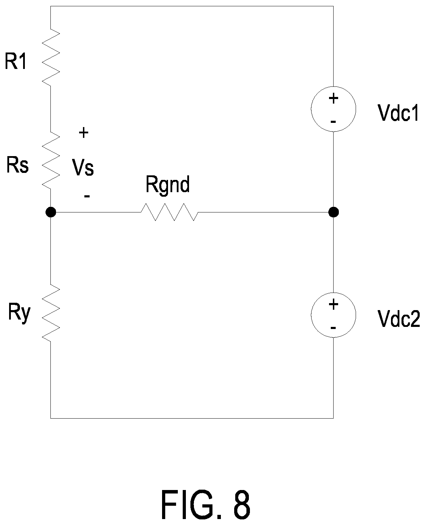

An insulation resistance between the negative line 13 and the protective earthing terminal PE may be represented by a resistor Ry across the negative line 13 and the protective earthing terminal PE, as shown in FIG. 7. FIG. 8 schematically shows a simplified equivalent circuit of FIG. 7. Please refer to FIG. 7 and FIG. 8 in conjunction with FIG. 4. The insulation resistance between the negative line 13 and the protective earthing terminal PE is determined to be abnormal if the resistance of resistor Ry is less than a preset minimum value Ry(min). When the resistance of resistor Ry is equal to the preset minimum value Ry(min), the sensing voltage Vs is equal to a sixth threshold voltage Vth6.

$$Vth6 = \frac{Rs \cdot (Ry(min)+2Rgnd)}{(R1+Rs)(Rgnd+Ry(min))+Rgnd \cdot Ry(min)} \cdot Vdc1 \qquad (7)$$

When the resistance of resistor Ry is close to or equal to zero, the sensing voltage Vs is equal to a seventh threshold voltage Vth7.

$$Vth7 = \frac{2Rs}{R1+Rs} \cdot Vdc1 \qquad (8)$$

In other words, if the resistance of resistor Ry decreases from the preset minimum value Ry(min) to a value close to or equal to zero, the sensing voltage Vs increases from the sixth threshold voltage Vth6 to the seventh threshold voltage Vth7 correspondingly, represented by interval INT5 in FIG. 4.

Consequently, if the insulation resistance between the negative line 13 and the protective earthing terminal PE is abnormal, the sensing voltage Vs measured by detection circuit 14 would be within the interval INT5.

In addition, in order to avoid the overlap of the intervals (i.e., intervals INT3 and INT4 and intervals INT2 and INT5) of sensing voltage Vs, the fourth threshold voltage Vth4 should be greater than the fifth threshold voltage Vth5, and the sixth threshold voltage Vth6 should be greater than the third threshold voltage Vth3. According to equations (4)-(7), these requires that:

$$R1 + Rs > (k - 1)Rx(min) \qquad (9)$$

$$R1 + Rs > Ry(min) \qquad (10)$$

Consequently, according to the sensing voltage Vs across the sensing resistor Rs, the insulation resistance monitor device 14 of the present disclosure can detect and the distinguish the degradation or failure of the insulation resistance between the protective earthing terminal PE and any of the positive line 11, the neutral line 12 and the negative line 13.

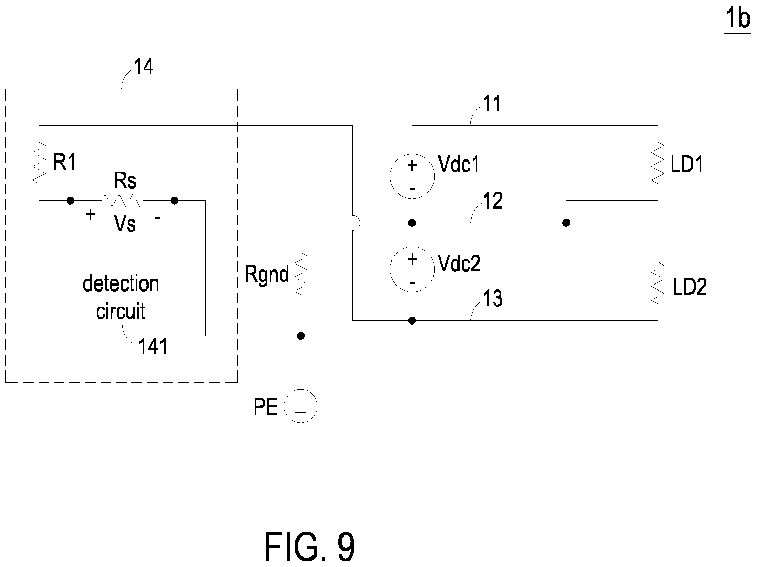

FIG. 9 is a schematic circuit diagram illustrating a DC power system according to a second embodiment of the present disclosure. The component parts and elements corresponding to those of FIG. 3A are designated by identical numeral references, and detailed descriptions thereof are omitted herein. In the DC power system 1b of the second embodiment shown in FIG. 9, the first terminal of the first resistor R1 of the insulation resistance monitor device 14 changes to be coupled to the negative line 13. In this embodiment, the operation principle of monitoring the insulation resistances is symmetrical to that in the embodiment of FIG. 3A, and thus detailed descriptions are omitted herein.

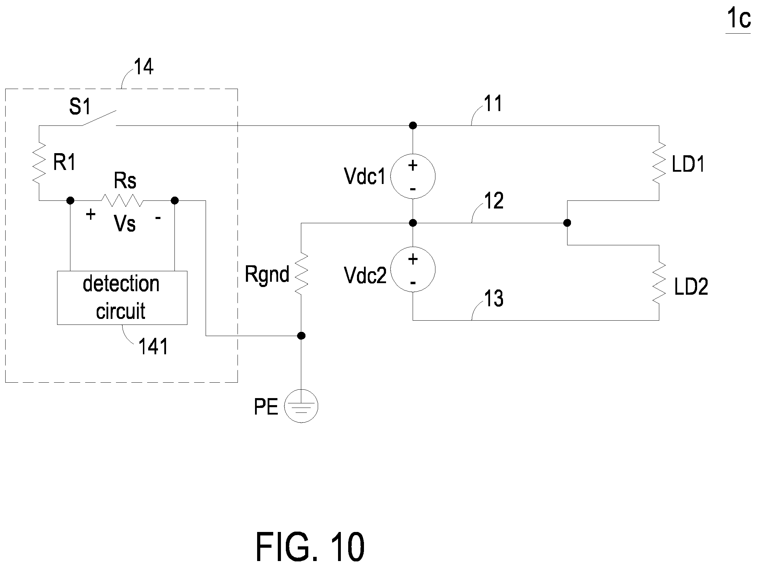

FIG. 10 is a schematic circuit diagram illustrating a DC power system according to a third embodiment of the present disclosure. The component parts and elements corresponding to those of FIG. 3A are designated by identical numeral references, and detailed descriptions thereof are omitted herein. As shown in FIG. 10, the insulation resistance monitor device 14 of the DC power system 1c is provided with disable function. Specifically, in this embodiment, the insulation resistance monitor device 14 further includes a first switch S1 electrically connected between the first terminal of the first resistor R1 and the positive line 11. In other words, the first terminal of the first resistor R1 is electrically connected to the positive line 11 through the first switch S1. Accordingly, when the requirement of monitoring insulation resistances is needed, the first switch S1 turns on, and the insulation resistance monitor device 14 detects whether the insulation resistances are abnormal through measuring the sensing voltage Vs across the sensing resistor Rs. When the requirement of monitoring insulation resistances is not needed, the first switch S1 turns off, and the insulation resistance monitor device 14 is disabled.

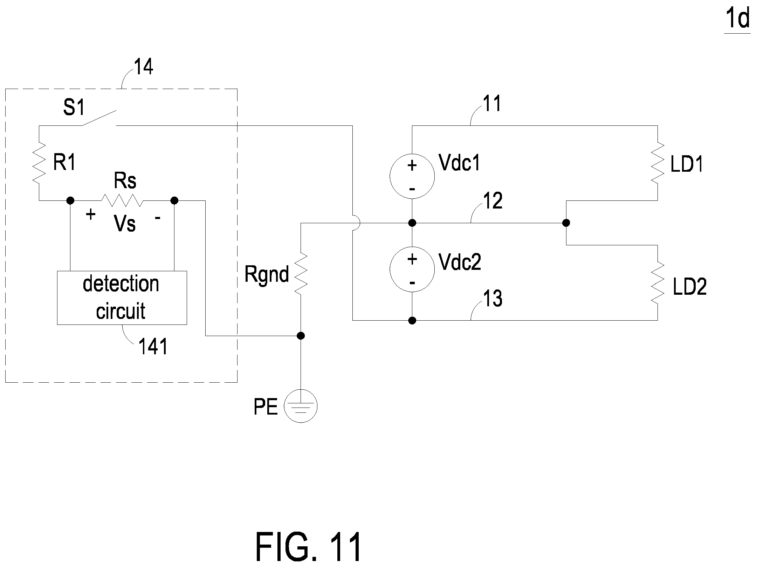

FIG. 11 is a schematic circuit diagram illustrating a DC power system according to a fourth embodiment of the present disclosure. The component parts and elements corresponding to those of FIG. 10 are designated by identical numeral references, and detailed descriptions thereof are omitted herein. As shown in FIG. 11, the insulation resistance monitor device 14 of the DC power system 1d is provided with disable function. Specifically, in this embodiment, the first switch S1 of the insulation resistance monitor device 14 is electrically connected between the first terminal of the first resistor R1 and the negative line 13. In other words, the first terminal of the first resistor R1 is electrically connected to the negative line 13 through the first switch S1. Accordingly, when the requirement of monitoring insulation resistances is needed, the first switch S1 turns on, and the insulation resistance monitor device 14 detects whether the insulation resistances are abnormal through measuring the sensing voltage Vs across the sensing resistor Rs. When the requirement of monitoring insulation resistances is not needed, the first switch S1 turns off, and the insulation resistance monitor device 14 is disabled.

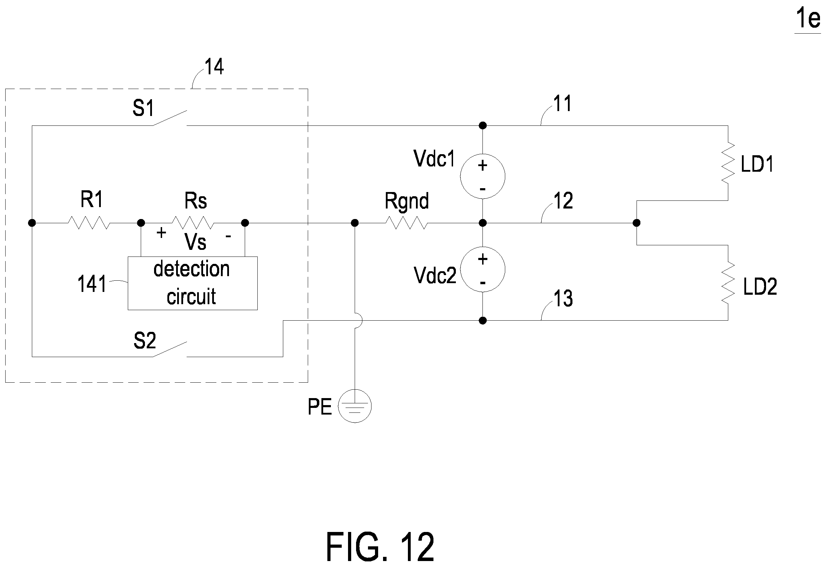

FIG. 12 is a schematic circuit diagram illustrating a DC power system according to a fifth embodiment of the present disclosure. The component parts and elements corresponding to those of FIG. 3A are designated by identical numeral references, and detailed descriptions thereof are omitted herein. In this embodiment, as shown in FIG. 12, the insulation resistance monitor device 14 of the DC power system 1e further includes a first switch S1 and a second switch S2. The first switch S1 is electrically connected between the first terminal of the first resistor R1 and the positive line 11, and the second switch S2 is electrically connected between the first terminal of the first resistor R1 and the negative line 13. The first switch S1 and the second switch S2 are configured to allow the first terminal of the first resistor R1 to be selectively coupled to the positive line 11 or the negative line 13.

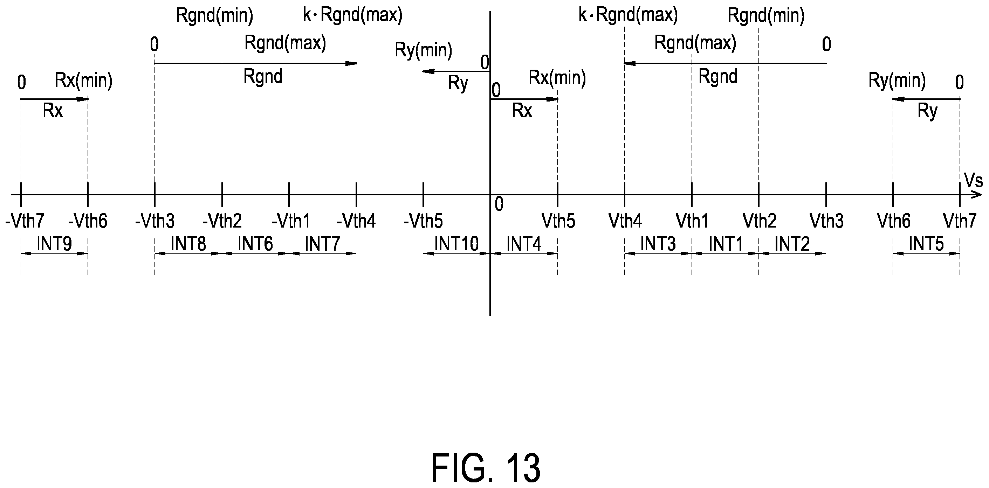

FIG. 13 schematically shows relations between the sensing voltage Vs and the status of insulation resistances in the DC power system 1e of FIG. 12. Please refer to FIG. 12 and FIG. 13. When the first switch S1 turns on and the second switch S2 turns off, the sensing voltage Vs is positive, and the relations between the sensing voltage Vs and the insulation resistances are the same as that shown in FIG. 4. When the first switch S1 turns off and the second switch S2 turns on, the sensing voltage Vs is negative.

If the resistance of grounding resistor Rgnd is within the acceptable tolerance range from the lower bound of grounding resistance Rgnd(min) to the upper bound of grounding resistance Rgnd(max), the insulation resistance between the protective earthing terminal PE and any of the positive line 11, the neutral line 12 and the negative line 13 is normal, and the sensing voltage Vs falls within the interval INT6. It is noted that the sensing voltage Vs equals -Vth1 when the resistance of grounding resistor Rgnd equals the upper bound of grounding resistance Rgnd(max), and the sensing voltage Vs equals -Vth2 when the resistance of grounding resistor Rgnd equals the lower bound of grounding resistance Rgnd(min).

If the resistance of grounding resistor Rgnd is between the upper bound of grounding resistance Rgnd(max) and k times of the upper bound of grounding resistance Rgnd(max), the insulation resistance between the neutral line 12 and the protective earthing terminal PE is too high, and the sensing voltage Vs falls within the interval INT7. It is noted that the sensing voltage Vs equals -Vth4 when the resistance of grounding resistor Rgnd equals k times of the upper bound of grounding resistance Rgnd(max).

If the resistance of grounding resistor Rgnd is between the lower bound of grounding resistance Rgnd(min) and zero, the insulation resistance between the neutral line 12 and the protective earthing terminal PE is too low, and the sensing voltage Vs falls within the interval INT8. It is noted that the sensing voltage Vs equals -Vth3 when the resistance of grounding resistor Rgnd is close to or equal to zero.

If the resistance of resistor Rx is between the preset minimum value Rx(min) and zero, the insulation resistance between the positive line 11 and the protective earthing terminal PE is abnormal, and the sensing voltage Vs falls within the interval INT9. It is noted that the sensing voltage Vs equals -Vth6 when the resistance of resistor Rx equals the preset minimum value Rx(min), and the sensing voltage Vs equals -Vth7 when the resistance of resistor Rx is close to or equal to zero.

If the resistance of resistor Ry is between the preset minimum value Ry(min) and zero, the insulation resistance between the negative line 13 and the protective earthing terminal PE is abnormal, and the sensing voltage Vs falls within the interval INT10. It is noted that the sensing voltage Vs equals -Vth5 when the resistance of resistor Ry equals the preset minimum value Ry(min), and the sensing voltage Vs is close to or equal to zero when the resistance of resistor Ry is close to or equal to zero.

Generally, the resistance of grounding resistor Rgnd would not exceed k times of the upper bound of grounding resistance Rgnd(max). However, if the resistance of grounding resistor Rgnd exceeds k times of the upper bound of grounding resistance Rgnd(max) and increases to a value which causes the sensing voltage Vs to fall within the interval INT4 or INT10, it becomes difficult to distinguish whether the abnormality is in the insulation resistance between the protective earthing terminal PE and the neutral line 12 or in the insulation resistance between the protective earthing terminal PE and the positive line 11/negative line 13.

This problem can be solved by the embodiment shown in FIG. 12 through switching the insulation resistance monitor device 14 between connecting to the positive line 11 and connecting to the negative line 13. For example, as shown in FIG. 12 and FIG. 13, under the circumstance that the first switch S1 turns on and the second switch S2 turns off, if the sensing voltage Vs falls within the interval INT4, the first terminal of the first resistor R1 is switched to connect to the negative line 13 by turning off the first switch S1 and turning on the second switch S2. Under the circumstance that the first switch S1 turns off and the second switch S2 turns on, if the sensing voltage Vs falls within the interval INT9, the insulation resistance between the protective earthing terminal PE and the positive line 11 is determined to be abnormal. Alternatively, if the sensing voltage Vs falls within the interval INT10, the insulation resistance between the protective earthing terminal PE and the neutral line 12 is determined to be abnormal.

Similarly, under the circumstance that the first switch S1 turns off and the second switch S2 turns on, if the sensing voltage Vs falls within the interval INT10, the first terminal of the first resistor R1 is switched to connect to the positive line 11 by turning on the first switch S1 and turning off the second switch S2. Under the circumstance that the first switch S1 turns on and the second switch S2 turns off, if the sensing voltage Vs falls within the interval INT5, the insulation resistance between the protective earthing terminal PE and the negative line 13 is determined to be abnormal. Alternatively, if the sensing voltage Vs falls within the interval INT4, the insulation resistance between the protective earthing terminal PE and the neutral line 12 is determined to be abnormal.

Consequently, the insulation resistance monitor device 14 in this embodiment is able to accurately determine the abnormal insulation resistance by switching between connecting to the positive line 11 and connecting to the negative line 13.

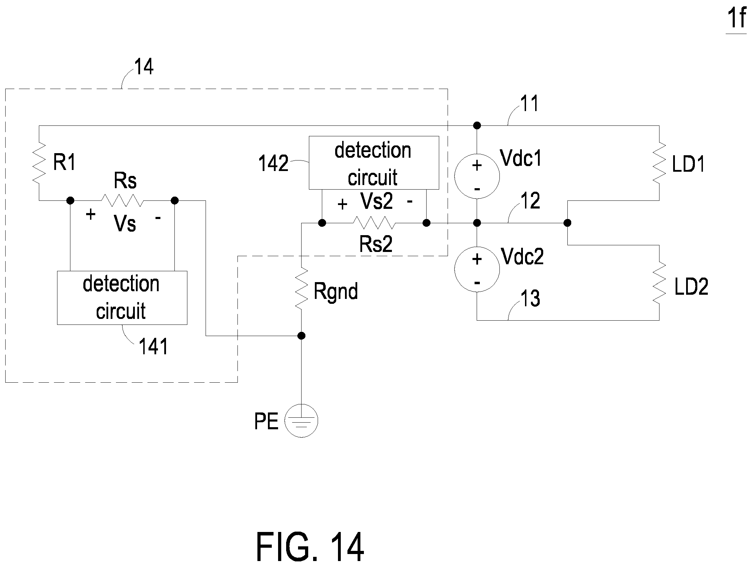

FIG. 14 is a schematic circuit diagram illustrating a DC power system according to a sixth embodiment of the present disclosure. The component parts and elements corresponding to those of FIG. 3A are designated by identical numeral references, and detailed descriptions thereof are omitted herein. In this embodiment, as shown in FIG. 14, the insulation resistance monitor device 14 of the DC power system 1f further includes another sensing resistor Rs2 (also referred to as a second sensing resistor) and another detection circuit 142 (also referred to as a second detection circuit). The sensing resistor Rs2 is electrically connected between the grounding resistor Rgnd and the neutral line 12, the resistance of sensing resistor Rs2 is much smaller than the resistance of grounding resistor Rgnd. The detection circuit 142 is electrically connected to two terminals of the sensing resistor Rs2, and is configured to measure a sensing voltage Vs2 across the sensing resistor Rs2. By further considering the sensing voltage Vs2, the insulation resistance monitor device 14 in this embodiment is also able to accurately determine the abnormal insulation resistance. For example, under the circumstance that the sensing voltage Vs falls within the interval INT4 or INT10, if the sensing voltage Vs2 is close to or equal to zero, it means that the resistance of grounding resistor Rgnd is too high and causes open-circuit, and thus the insulation resistance between the protective earthing terminal PE and the neutral line 12 is abnormal. Further, if the sensing voltage Vs2 is not zero and the sensing voltage Vs falls within the interval INT4, the insulation resistance between the protective earthing terminal PE and the positive line 11 is abnormal; and if the sensing voltage Vs2 is not zero and the sensing voltage Vs falls within the interval INT10, the insulation resistance between the protective earthing terminal PE and the negative line 13 is abnormal.

**Claims**

1. An insulation resistance monitor device (14) adapted to a DC power system (1a, 1b, 1c, 1d, 1e, 1f) comprising a positive line (11), a neutral line (12), a negative line (13), a protective earthing terminal (PE), and a grounding resistor (Rgnd), wherein the grounding resistor (Rgnd) is electrically connected between the neutral line (12) and the protective earthing terminal (PE), **characterized in that** the insulation resistance monitor device (14) comprises:

   a first resistor (R1), having a first terminal coupled to the positive line (12) or the negative line (13) of the DC power system (1a, 1b, 1c, 1d, 1e, 1f);
   a first sensing resistor (Rs), having a first terminal coupled to a second terminal of the first resistor (R1) and a second terminal coupled to the protective earthing terminal (PE); and
   a first detection circuit (141), electrically connected to the first and second terminals of the first sensing resistor (Rs), and configured to measure a sensing voltage across the first sensing resistor (Rs) and detect whether an insulation resistance between the protective earthing terminal (PE) and any of the positive line (11), the neutral line (12), and the negative line (13) is abnormal according to the sensing voltage.

2. The insulation resistance monitor device (14) according to claim 1, wherein the first detection circuit (141) is configured to determine that the insulation resistance between the protective earthing terminal (PE) and any of the positive line (11), the neutral line (12), and the negative line (13) is normal if the sensing voltage is between a first threshold voltage (Vth1) and a second threshold voltage (Vth2), wherein when a resistance of the grounding resistor (Rgnd) is between a lower bound of grounding resistance (Rgnd(min)) and an upper bound of grounding resistance (Rgnd(max)), the sensing voltage is between the second threshold voltage (Vth2) and the first threshold voltage (Vth1) correspondingly.

3. The insulation resistance monitor device (14) according to claim 2, wherein the first terminal of the first resistor (R1) is coupled to the positive line (11), and when the resistance of the grounding resistor (Rgnd) increases from the lower bound of grounding resistance (Rgnd(min)) to the upper bound of grounding resistance (Rgnd(max)), the sensing voltage decreases from the second threshold voltage (Vth2) to the first threshold voltage (Vth1) correspondingly.

4. The insulation resistance monitor device (14) according to claim 3, wherein the first detection circuit (141) is configured to determine that an insulation resistance between the protective earthing terminal (PE) and the neutral line (12) is abnormal if the sensing voltage is between the second threshold voltage (Vth2) and a third threshold voltage (Vth3), wherein when the resistance of the grounding resistor (Rgnd) decreases from the lower bound of grounding resistance (Rgnd(min)) to a value close to or equal to zero, the sensing voltage increases from the second threshold voltage (Vth2) to the third threshold voltage (Vth3) correspondingly.

5. The insulation resistance monitor device (14) according to claim 3, wherein the first detection circuit (141) is configured to determine that an insulation resistance between the protective earthing terminal (PE) and the neutral line (12) is abnormal if the sensing voltage is between the first threshold voltage (Vth1) and a third threshold voltage (Vth3), wherein when the resistance of the grounding resistor (Rgnd) increases from the upper bound of grounding resistance (Rgnd(max)) to k times of the upper bound of grounding resistance (Rgnd(max)), the sensing voltage decreases from the first threshold voltage (Vth1) to the third threshold voltage (Vth3) correspondingly, where k is an integer greater than 1.

6. The insulation resistance monitor device (14) according to claim 2, wherein the first terminal of the first resistor (R1) is coupled to the negative line (13), and when the resistance of the grounding resistor (Rgnd) increases from the lower bound of grounding resistance (Rgnd(min)) to the upper bound of grounding resistance (Rgnd(max)), the sensing voltage increases from the first threshold voltage (Vth1) to the second threshold voltage (Vth2) correspondingly.

7. The insulation resistance monitor device (14) according to claim 6, wherein the first detection circuit (141) is configured to determine that an insulation resistance between the protective earthing terminal (PE) and the neutral line (12) is abnormal if the sensing voltage is between the second threshold voltage (Vth2) and a third threshold voltage (Vth3), wherein when the resistance of the grounding resistor (Rgnd) increases from the upper bound of grounding resistance (Rgnd(max)) to k times of the upper bound of grounding resistance (Rgnd(max)), the sensing voltage increases from the second threshold voltage (Vth2) to the third threshold voltage (Vth3) correspondingly, where k is an integer greater than 1.

8. The insulation resistance monitor device (14) according to claim 6, wherein the first detection circuit (141) is configured to determine that an insulation resistance between the protective earthing terminal (PE) and the neutral line (12) is abnormal if the sensing voltage is between the first threshold voltage (Vth1) and a third threshold voltage (Vth3), wherein when the resistance of the grounding resistor (Rgnd) decreases from the lower bound of grounding resistance (Rgnd(min)) to a value close to or equal to zero, the sensing voltage decreases from the first threshold voltage (Vth1) to the third threshold voltage (Vth3) correspondingly.

9. The insulation resistance monitor device (14) according to any one of the above claims, wherein the first detection circuit (141) is configured to determine that an insulation resistance between the protective earthing terminal (PE) and the negative line (13) is abnormal if the sensing voltage is between a fourth threshold voltage (Vth4) and a fifth threshold voltage (Vth5), and the fourth threshold voltage (Vth4) is greater than the third threshold voltage (Vth3) and less than the fifth threshold voltage (Vth5), wherein when the insulation resistance between the protective earthing terminal (PE) and the negative line (13) decreases from a preset minimum value (Ry(min)) to a value close to or equal to zero, the sensing voltage increases from the fourth threshold voltage (Vth4) to the fifth threshold voltage (Vth5) correspondingly.

10. The insulation resistance monitor device (14) according to any one of the above claims, wherein the first detection circuit (141) is configured to determine that an insulation resistance between the protective earthing terminal (PE) and the positive line (11) is abnormal if the sensing voltage is between a fourth threshold voltage (Vth4) and a fifth threshold voltage (Vth5), and the fourth threshold voltage (Vth4) is greater than the fifth threshold voltage (Vth5) and less than the third threshold voltage (Vth3), wherein when the insulation resistance between the protective earthing terminal (PE) and the positive line (11) decreases from a preset minimum value (Rx(min)) to a value close to or equal to zero, the sensing voltage decreases from the fourth threshold voltage (Vth4) to the fifth threshold voltage (Vth5) correspondingly.

11. The insulation resistance monitor device (14) according to claim 1, further comprising a switch (S1) electrically connected to the first terminal of the first resistor (R1) and the positive line (11), and the first terminal of the first resistor (R1) is coupled to the positive line (11) through the switch (S1).

12. The insulation resistance monitor device (14) according to claim 1, further comprising a switch (S1) electrically connected to the first terminal of the first resistor (R1) and the negative line (13), and the first terminal of the first resistor (R1) is coupled to the negative line (13) through the switch (S1).

13. The insulation resistance monitor device (14) according to claim 1, further comprising a first switch (S1) and a second switch (S2), wherein the first switch (S1) is electrically connected between the first terminal of the first resistor (R1) and the positive line (11), the second switch (S2) is electrically connected between the first terminal of the first resistor (R1) and the negative line (13), and the first switch (S1) and the second switch (S2) are configured to allow the first terminal of the first resistor (R1) to be selectively coupled to the positive line (11) or the negative line (13).

14. The insulation resistance monitor device (14) according to claim 1, further comprising a second sensing resistor (Rs2) and a second detection circuit (142), wherein the second sensing resistor (Rs2) is electrically connected between the grounding resistor (Rgnd) and the neutral line (12), and the second detection circuit (142) is electrically connected to two terminals of the second sensing resistor (Rs2) and is configured to measure a sensing voltage across the second sensing resistor (Rs2).

15. ADC power system (1a, 1b, 1c, 1d, 1e, 1f), **characterized by** comprising:

a positive line (11), a neutral line (12), a negative line (13), and a protective earthing terminal (PE);
a first DC source (Vdc1), having a positive terminal electrically connected to the positive line (11) and a negative terminal electrically connected to the neutral line (12);

a second DC source (Vdc2), having a positive terminal electrically connected to the neutral line (12) and a negative terminal electrically connected to the negative line (13);

a grounding resistor (Rgnd), electrically connected between the neutral line (12) and the protective earthing terminal (PE); and

an insulation resistance monitor device (14), comprising:

a first resistor (R1), having a first terminal coupled to the positive line (12) or the negative line (13) of the DC power system (1a, 1b, 1c, 1d, 1e, 1f);

a first sensing resistor (Rs), having a first terminal coupled to a second terminal of the first resistor (R1) and a second terminal coupled to the protective earthing terminal (PE); and

a first detection circuit (141), electrically connected to the first and second terminals of the first sensing resistor (Rs), and configured to measure a sensing voltage across the first sensing resistor (Rs) and detect whether an insulation resistance between the protective earthing terminal (PE) and any of the positive line (11), the neutral line (12) and the negative line (13) is abnormal according to the sensing voltage.

16. The DC power system (1a, 1b, 1c, 1d, 1e, 1f) according to claim 15, wherein the first DC source (Vdc1) is formed by a single power source or by power sources electrically connected in parallel, the second DC source (Vdc2) is formed by a single power source or by power sources electrically connected in parallel, and voltage magnitudes of the first and second DC sources (Vdc1, Vdc2) are equal.

17. The DC power system (1a, 1b, 1c, 1d, 1e, 1f) according to claim 15 or 16, further comprising a DC load (LD1) electrically connected to the positive line (11), the neutral line (12) and the negative line (13), wherein a first part of the DC load (LD1) receives power from the first DC source (Vdc1) through the positive line (11) and the neutral line (12), and a second part of the DC load (LD1) receives power from the second DC source (Vdc2) through the neutral line (12) and the negative line (13).

18. The DC power system (1a, 1b, 1c, 1d, 1e, 1f) according to any one of claims 15 to 17, further comprising a first DC load (LD1) and a second DC load (LD2), wherein the first DC load (LD1) is electrically connected to the first DC source (Vdc1) through the positive line (11) and the neutral line (12), and the second DC load (LD2) is electrically connected to the second DC source (Vdc2) through the neutral line (12) and the negative line (13).

FIG. 1 PRIOR ART

EP 4 664 120 A1

FIG. 2 PRIOR ART

FIG. 3A

FIG. 3B

EP 4 664 120 A1

FIG. 4

FIG. 5

FIG. 6

FIG. 7

EP 4 664 120 A1

FIG. 8

EP 4 664 120 A1

FIG. 9

1c

LD1

LD2

11

12

13

Vdc1

Vdc2

Rgnd

PE

14

S1

R1

Rs

Vs

detection circuit

141

FIG. 10

FIG. 11

FIG. 12

FIG. 13

EP 4 664 120 A1

**FIG. 14**

Europäisches
Patentamt

European
Patent Office

Office européen
des brevets

# EUROPEAN SEARCH REPORT

**Application Number**

EP 25 18 2374

## DOCUMENTS CONSIDERED TO BE RELEVANT

| Category | Citation of document with indication, where appropriate, of relevant passages | Relevant to claim |
|---|---|---|
| X | WO 2012/120683 A1 (MITSUBISHI ELECTRIC CORP [JP]; IMAI YOSHITO [JP]) 13 September 2012 (2012-09-13) | 1-10, 15-18 |
| A | * abstract; figures 1-5 * * page 1, paragraph 1 - page 8, paragraph 4 * ----- | 11-14 |
| A | CN 103 176 049 A (BYD CO LTD) 26 June 2013 (2013-06-26) * the whole document * ----- | 1-18 |

**CLASSIFICATION OF THE APPLICATION (IPC)**

INV.
G01R27/02
G01R27/18
G01R31/40
G01R31/52

**TECHNICAL FIELDS SEARCHED (IPC)**

G01R

The present search report has been drawn up for all claims

| Place of search | Date of completion of the search | Examiner |
|---|---|---|
| Munich | 3 November 2025 | Kleiber, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 2374

This annex lists the patent family members relating to the patent documents cited in  the above-mentioned European search report.
The members are as contained in the European Patent Office EDP file on
The European Patent Office is in no way liable for these particulars which are merely given for the purpose of information.

03-11-2025

| Patent document cited in search report | Publication date | Patent family member(s) | Publication date |
|---|---|---|---|
| WO 2012120683 A1 | 13-09-2012 | JP WO2012120683 A1<br>WO 2012120683 A1 | 07-07-2014<br>13-09-2012 |
| CN 103176049 A | 26-06-2013 | NONE | |

EPO FORM P0459

For more details about this annex : see Official Journal of the European Patent Office, No. 12/82